(19) Europäisches Patentamt
European Patent Office
Office européen des brevets

(11) **EP 3 919 928 A1**

(12) **DEMANDE DE BREVET EUROPEEN**

(43) Date de publication:
**08.12.2021 Bulletin 2021/49**

(51) Int Cl.:
***G01R 33/26*** *(2006.01)*     ***G01R 33/022*** *(2006.01)*

(21) Numéro de dépôt: **21177200.9**

(22) Date de dépôt: **01.06.2021**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **02.06.2020 FR 2005774**

(71) Demandeur: **Commissariat à l'énergie atomique et aux énergies alternatives**
**75015 Paris (FR)**

(72) Inventeurs:
• **LE GAL, Gwenael**
**38054 GRENOBLE Cedex 09 (FR)**
• **PALACIOS LALOY, Agustin**
**38054 GRENOBLE Cedex 09 (FR)**

(74) Mandataire: **Brevalex**
**95, rue d'Amsterdam**
**75378 Paris Cedex 8 (FR)**

(54) **MAGNETOMETRE A POMPAGE OPTIQUE TRI-AXE POUR MESURE GRADIOMETRIQUE**

(57)     L'invention porte sur un magnétomètre à pompage optique vectoriel tri-axe qui comprend une cellule (1) remplie d'un gaz atomique soumis à un champ magnétique ambiant dont la projection sur trois axes de coordonnées rectangulaires en définit trois composantes et un photodétecteur (10) agencé de manière à recevoir un faisceau de sonde ayant traversé la cellule.

Le photodétecteur (10) comprend une pluralité d'unités de mesure agencées dans un plan transverse à une direction de propagation du faisceau de sonde, les unités de mesure fournissant chacune un signal de photodétection.

Le magnétomètre comprend en outre unité de traitement (6) configurée :
- pour déterminer, pour chaque unité de mesure et à partir du signal de photodétection fournie par l'unité de mesure, une mesure, associée à l'unité de mesure, de chacune des trois composantes du champ magnétique ambiant ; et
- pour calculer au moins une différence entre les mesures, associées à des unités de mesure différentes, d'une composante du champ magnétique et délivrer un signal de mesure gradiométrique comprenant l'au moins une différence calculée.

FIG. 1

**Description**

**DOMAINE TECHNIQUE**

Le domaine de l'invention est celui de la gradiométrie magnétique, à savoir la mesure d'un gradient spatial d'un champ magnétique. L'invention concerne plus particulièrement la réalisation d'une mesure gradiométrique au moyen d'un magnétomètre à pompage optique.

**TECHNIQUE ANTÉRIEURE**

Une mesure du gradient de champ magnétique est habituellement réalisée en se servant de la soustraction des signaux de plusieurs magnétomètres répartis dans l'espace. Une telle mesure permet de rejeter le bruit de mode commun entre les différents points de mesure et ainsi d'améliorer le niveau de sensibilité de la mesure magnétométrique. La gradiométrie apporte ainsi des informations complémentaires à la magnétométrie, notamment du fait que la dépendance spatiale des mesures est différente, ce qui permet de localiser les sources de champ magnétique.

Une mesure gradiométrique peut également être réalisée au moyen de capteurs SQUID qui ont la capacité de réaliser intrinsèquement la différence de champ magnétique entre deux zones de mesure. En effet, les capteurs SQUID mesurent le flux magnétique traversant une spire métallique comportant des jonctions supraconductrices. En disposant deux spires connectées entre elles de sorte que les flux traversants chacune d'entre elles induisent des courants de sens opposés, le courant résultant mesuré est directement proportionnel à la différence des flux magnétiques traversant les spires.

En revanche, les capteurs SQUID ne permettent de mesurer qu'une seule composante du champ magnétique, celle orthogonale au plan de la spire. Deux types de gradiomètres peuvent ainsi être réalisés avec des capteurs SQUIDs :

- des gradiomètres longitudinaux où les deux spires sont dans deux plans parallèles et séparées d'une distance b appelée base du gradiomètre. Une telle configuration permet de mesurer le gradient de champ magnétique dans la direction longitudinale au champ magnétique ($\partial B_z/\partial z$) ;
- des gradiomètres transverses où les deux spires sont dans le même plan et séparées d'une base b, distance entre les deux centres de chaque spire. Cette configuration permet de mesurer le gradient d'une composante du champ magnétique par rapport à une des directions transverses à la composante ($\partial B_z/\partial x$ ou $\partial B_z/\partial y$).

Ces gradiomètres ont pour inconvénient qu'une fois le capteur réalisé, la base b est fixée ainsi que la direction de mesure du gradient (transverse ou longitudinale). Par ailleurs, les capteurs SQUID requièrent un refroidissement cryogénique pour fonctionner et sont généralement placés à l'intérieur d'enceintes magnétiquement blindées pour s'affranchir des champs magnétiques extérieurs qui pourraient perturber les mesures. La taille de ces enceintes doit être suffisamment grande pour contenir le récipient cryogénique ce qui aboutit à des fortes contraintes de coût ainsi que sur l'architecture des bâtiments contenant ces dispositifs, contraintes qui nuisent à leur démocratisation.

Une alternative au capteur SQUID est le magnétomètre à pompage optique qui utilise un gaz atomique confiné dans une cellule, typiquement de l'hélium métastable ou des gaz d'alcalins, en tant qu'élément sensible. Un tel magnétomètre, qui peut prendre différentes configurations, permet de remonter au champ magnétique en exploitant les trois processus suivants qui ont lieu de façon soit séquentielle soit concomitante :

1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.

2) Ces états atomiques évoluent sous l'effet du champ magnétique, notamment sous l'effet Zeeman qui correspond à des décalages des niveaux d'énergie en fonction du champ magnétique auquel sont soumis les atomes.

3) Les propriétés optiques du milieu atomique subissent alors des modifications qui dépendent de l'état des atomes. On peut ainsi par une mesure optique, par exemple par une mesure d'absorption optique, remonter au décalage Zeeman subi et en déduire une mesure du champ magnétique dans lequel est plongée la cellule.

On distingue deux grandes catégories de magnétomètres à pompage optique selon le type de pompage réalisé.

Dans la catégorie la plus répandue, le pompage est réalisé avec un faisceau de pompage émettant une lumière à polarisation circulaire et le gaz atomique acquiert un état dit orienté caractérisé par une valeur moyenne non nulle de son moment magnétique selon un axe, qui se trouve être celui de propagation du faisceau de pompage.

Dans l'autre catégorie, le pompage est réalisé avec un faisceau de pompage émettant une lumière en polarisation linéaire et le gaz atomique acquiert un état dit aligné caractérisé par une valeur nulle de son moment magnétique, mais par une valeur non nulle d'une grandeur du type ($3 F_z^2 - F^2$) où F est le moment cinétique total et $F_z$ le moment cinétique le long de la direction de polarisation du faisceau de pompage.

La caractérisation des états atomiques (étape 3 ci-dessus) peut être réalisée selon au moins deux schémas :

- en mesurant l'absorption d'un faisceau accordé (ou très proche) à la transition atomique considérée (le faisceau utilisé pour le pompage ou un faisceau dit « sonde » de même polarisation que le faisceau utilisé pour le pompage) ;
- en utilisant un faisceau dit « sonde » de polarisation linéaire et décalé en longueur d'onde par rapport à la transition atomique considérée. Selon le type de polarisation atomique (orientation ou alignement), ce faisceau subit une modification de sa polarisation (rotation du plan de polarisation dans le cas de l'orientation, création d'une composante polarisée circulairement dans le cas de l'alignement) qui peut être mesurée en séparant deux des états de polarisation du faisceau (les deux polarisations à 45° dans le cas de l'orientation, les deux polarisations circulaires dans le cas de l'alignement) puis en les photodétectant de manière à identifier l'accroissement d'une des polarisations par rapport à l'autre. On parle alors de mesure polarimétrique.

Deux effets physiques permettent de réaliser une mesure vectorielle du champ magnétique. Il s'agit de l'effet Hanle et des résonances paramétriques.

Le premier effet est principalement utilisé dans les magnétomètres en orientation et se décline sous différentes variantes pour être sondé, principalement en polarimétrie, à travers une mesure de rotation Faraday ou une modulation de la polarisation du faisceau de sonde. Son avantage principal est qu'il permet une mesure « tout-optique » d'une ou deux composantes du champ magnétique, sans nécessiter l'application de champ(s) magnétique(s) radiofréquence (RF). Cependant les configurations Hanle en orientation souffrent d'un manque de compacité, nécessitant plusieurs faisceaux lasers (de pompe et de sonde) se propageant orthogonalement les uns aux autres.

Les résonances paramétriques sont utilisées dans les magnétomètres en orientation et en alignement, principalement en absorption. La différence avec l'effet Hanle réside dans l'application de champs magnétiques radiofréquences sur la cellule contenant l'élément sensible qui permettent de faire apparaître des dépendances linéaires de certaines composantes fréquentielles du signal de photodétection en fonction des composantes du champ magnétique. L'avantage de ce type d'architecture est qu'une mesure d'une ou plusieurs composantes du champ magnétique peut être réalisée en utilisant un seul faisceau laser agissant comme pompe et sonde, permettant ainsi de réaliser des magnétomètres plus compacts. L'utilisation de cet effet est ainsi souvent préférée pour des applications médicales du type magnétoencéphalographie ou magnétocardiographie qui nécessitent une forte densité de capteurs sur la zone étudiée.

Des travaux de gradiométrie avec des magnétomètres à pompage optiques utilisant un photodétecteur résolu spatialement ont été réalisés dans l'équipe de M. V. Romalis à l'Université de Princeton (Kominis et al., Nature Vol 422, 2003). L'architecture utilisée repose sur l'effet Hanle pour mesurer une seule composante du champ magnétique (celle perpendiculaire à la direction de propagation du faisceau de pompe et du faisceau de sonde). Les atomes, pompés en orientation, sont sondés par rotation Faraday modulée. Le signal est recueilli sur une photodiode segmentée dans la direction longitudinale à la composante du champ magnétique mesurée. De cette manière, il est possible de mesurer le gradient longitudinal de la composante du champ magnétique $(\partial B_y/\partial y)$.

D'autres travaux réalisés ultérieurement dans la même équipe exploitent une matrice de 16*16 photodiodes permettant ainsi de mesurer le gradient longitudinal de la composante du champ magnétique $(\partial B_y/\partial y)$ ainsi qu'un gradient transverse à cette composante $(\partial B_y/\partial z)$ tout en ayant une base reconfigurable.

Plus récemment, une architecture similaire à celles susmentionnées a été adaptée à une mesure de magnétoencéphalographie (Zhang et al., AIP Advances 8, 125028, 2018). La seule différence réside dans le fait que le signal est analysé sur les deux bases de polarisations linéaires au lieu d'utiliser une modulation de la polarisation du faisceau de sonde pour obtenir le signal de mesure. Une matrice de 2*2 photodiodes est utilisée, ne permettant pas une base reconfigurable.

D'autres travaux utilisant un photodétecteur résolu spatialement ont été réalisés dans l'équipe de P. Schwindt à Albuquerque (Colombo et al., Optics Express Vol 24, n°14, 2016). L'architecture présentée dans cette publication est basée sur le principe des résonances paramétriques, permettant une propagation des faisceaux de pompe et de sonde selon la même direction et une mesure d'une des deux composantes du champ magnétique transverse à la direction de propagation des faisceaux lasers dans ce cas. Les faisceaux de pompe et de sonde sont séparés en 8 faisceaux différents (4 de pompe et 4 de sonde) par diffraction, chaque couple pompe/sonde copropageant étant envoyé aux 4 angles d'une cellule carrée contenant l'élément sensible. Une matrice de 2*2 photodiodes est utilisée pour recueillir l'information sur les 4 faisceaux de sonde. Cette architecture permet de mesurer le gradient longitudinal de la composante du champ magnétique $(\partial B_y/\partial y)$ ainsi qu'un gradient transverse à la même composante $(\partial B_y/\partial x)$ avec une base fixe dans les deux directions.

Tous les travaux susmentionnés ont été menés en mesurant une seule composante du champ magnétique. Ces architectures peuvent aisément être étendues à une mesure d'une seconde composante du champ magnétique, celle perpendiculaire à la direction de propagation du faisceau de pompe. Dans le cas des configurations Hanle, il faut pour cela ajouter un second faisceau de sonde se propageant perpendiculairement au faisceau de pompe et au premier faisceau de sonde. Dans le cas de l'architecture en résonances paramétriques, il faut ajouter un second champ magnétique radiofréquence orthogonal à la direction de propagation du faisceau de sonde et à la direction du premier champ radiofréquence. Il n'est pas possible d'obtenir la troisième et dernière composante du champ magnétique dans les configurations Hanle pompées en orientation. Dans le cas des résonances paramétriques pompées en orientation, il est possible de l'obtenir par un effet de second ordre mais avec une sensibilité bien inférieure à celle des deux autres axes.

Du point de vue de la mesure de gradient, ces architectures ne permettent de mesurer au mieux que quatre composantes du tenseur de gradient (mesure de deux composantes du champ magnétique selon deux directions) sur les neuf qu'il comporte.

**EXPOSÉ DE L'INVENTION**

L'invention a pour objectif de proposer un magnétomètre à pompage optique apte à mesurer l'intégralité des composantes du tenseur de champ magnétique. L'invention concerne à cet effet un magnétomètre à pompage optique vectoriel tri-axe, comprenant :

-   une cellule remplie d'un gaz atomique soumis à un champ magnétique ambiant dont la projection sur trois axes de coordonnées rectangulaires en définit trois composantes,
-   un photodétecteur agencé de manière à recevoir un faisceau de sonde ayant traversé la cellule, et
-   une unité de traitement couplée au photodétecteur.

Le photodétecteur comprend une pluralité d'unités de mesure agencées dans un plan transverse à une direction de propagation du faisceau de sonde, les unités de mesure fournissant chacune un signal de photodétection.

L'unité de traitement est configurée :

-   pour déterminer, pour chaque unité de mesure et à partir du signal de photodétection fournie par l'unité de mesure, une mesure, associée à l'unité de mesure, de chacune des trois composantes du champ magnétique ambiant ; et
-   pour calculer au moins une différence entre les mesures, associées à des unités de mesure différentes, d'une composante du champ magnétique et délivrer un signal de mesure gradiométrique comprenant l'au moins une différence calculée.

Certains aspects préférés mais non limitatifs de ce magnétomètre sont les suivants :

les unités de mesure du photodétecteur sont agencées sous forme matricielle et sont au nombre d'au moins 3*3 ;
le photodétecteur est une matrice de photodiodes ;
le photodétecteur est un détecteur à transfert de charges ;

une unité de mesure du photodétecteur est formée d'une pluralité de pixels voisins du détecteur à transfert de charges, le signal de photodétection d'une unité de mesure correspondant à la moyenne des signaux de photodétection individuellement délivrés par les pixels de l'unité de mesure ;
il comprend en outre :

-   un circuit d'excitation de résonances paramétriques configuré de manière à ce qu'il induise dans la cellule un champ magnétique radiofréquence présentant deux composantes oscillant chacune à sa propre fréquence d'oscillation,
-   une source de pompage optique agencée pour émettre en direction de la cellule un faisceau de pompe accordé sur une transition atomique, le faisceau de sonde étant identique à ou distinct du faisceau de pompe,
-   un dispositif de polarisation configuré de manière à conférer une polarisation linéaire au faisceau de pompe,

et, pour déterminer une mesure, associée à une unité de mesure, de chacune des trois composantes du champ magnétique ambiant, l'unité de traitement est configurée pour réaliser une détection synchrone du signal de photodétection fourni par l'unité de mesure à un harmonique de chacune des fréquences d'oscillation et à un inter-harmonique desdites fréquences d'oscillation :
il comprend en outre :

-   un circuit d'excitation de résonances paramétriques configuré de manière à ce qu'il induise dans la cellule un champ magnétique radiofréquence présentant trois composantes oscillant chacune à sa propre fréquence d'oscillation,
-   une source de pompage optique agencée pour émettre en direction de la cellule un faisceau de pompe accordé sur une transition atomique, le faisceau de sonde étant identique à ou distinct du faisceau de pompe,
-   un dispositif de polarisation configuré de manière à conférer une polarisation elliptique au faisceau de pompe,

et, pour déterminer une mesure, associée à une unité de mesure, de chacune des trois composantes du champ magnétique ambiant, l'unité de traitement est configurée pour réaliser une détection synchrone du signal de photodétection fourni par l'unité de mesure à un harmonique de chacune des fréquences d'oscillation.

Les trois composantes du champ magnétique ambiant comprennent deux composantes, $B_x$ et $B_y$, transverses à la direction de propagation du faisceau de sonde et une composante, $B_z$, longitudinale à la direction de propagation du faisceau de sonde et le signal de mesure gradiométrique comprend :

- les gradients transverses de la composante $B_z$, $\partial B_z/\partial x$ et $\partial B_z/\partial y$,
- les gradients longitudinaux des composantes $B_x$ et $B_y$, $\partial B_x/\partial x$ et $\partial B_y/\partial y$,
- un gradient transverse de la composante $B_x$ et un gradient transverse de la composante $B_y$, $\partial B_x/\partial y$ et $\partial B_y/\partial x$.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

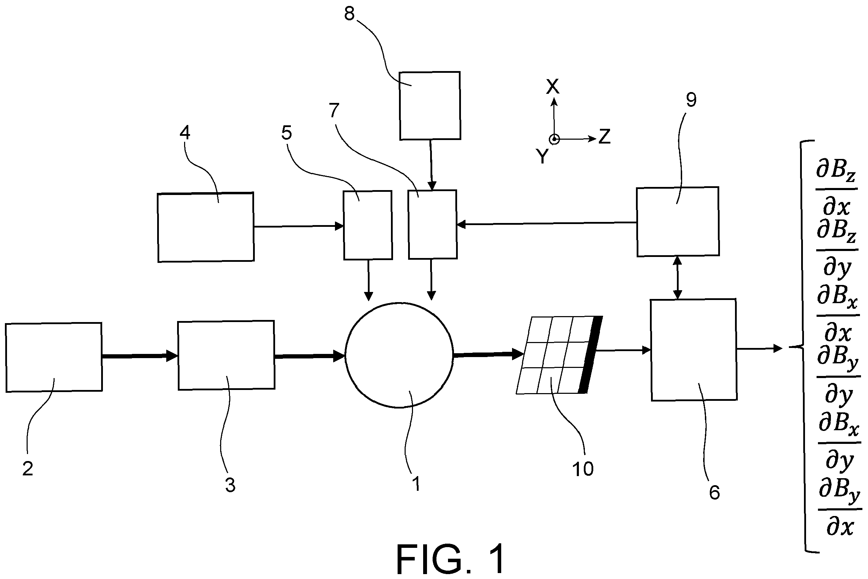

[Fig. 1] la figure 1 est un schéma d'un magnétomètre conforme à l'invention.

## EXPOSÉ DÉTAILLÉ DE MODES DE RÉALISATION PARTICULIERS

En référence à la figure 1, l'invention porte sur un magnétomètre à pompage optique qui comprend une cellule 1 remplie d'un gaz atomique, par exemple de l'hélium-4 ou un gaz alcalin, soumis à un champ magnétique ambiant $B_0$ dont la projection sur trois axes de coordonnées rectangulaires en définit trois composantes. Le champ magnétique ambiant se décompose ainsi en trois composantes $B_x$, $B_y$ et $B_z$ chacune selon l'un des axes de mesure du magnétomètre x, y et z.
Le magnétomètre selon l'invention est un magnétomètre vectoriel tri-axe, i.e. apte à réaliser une mesure de chacune des trois composantes $B_x$, $B_y$ et $B_z$ du champ magnétique ambiant. Comme cela sera décrit par la suite, le magnétomètre selon l'invention est également apte à réaliser une mesure d'un gradient spatial de la dérivée du champ magnétique ambiant.
La cellule 1 est éclairée par une source de pompage optique 2 apte à émettre en direction de la cellule 1 un faisceau de lumière, par exemple un faisceau laser, accordé à une longueur d'onde de pompage (ce faisceau est ainsi également désigné par faisceau de pompe). La longueur d'onde de pompage est accordée sur une raie de transition atomique, par exemple sur la raie $D_0$ à 1083 nm dans le cas de l'hélium-4. Le faisceau de lumière est polarisé au moyen d'un dispositif de polarisation 3 intercalé entre la source de pompage optique et la cellule ou directement intégré à la source de pompage optique.
Dans le cas où l'élément sensible est l'hélium-4, le magnétomètre comporte par ailleurs un système de décharge haute fréquence (HF), comprenant un générateur HF 4 et des bobines de surtension 5, pour amener les atomes du gaz atomique dans un état énergisé où ils sont aptes à subir la transition atomique lorsqu'ils sont éclairés par le faisceau de pompe, typiquement dans l'état métastable $2^3S_1$.
Le faisceau lumineux utilisé pour le pompage (i.e. la préparation des états atomiques nécessaires à une mesure du champ magnétique par pompage optique) peut également être utilisé en tant que faisceau de sonde pour la détection des états atomiques induits par le pompage, son absorption par les atomes portant en effet une information sur la valeur des composantes du champ magnétique statique auquel est soumis l'élément sensible. La figure 1 illustre un tel exemple de réalisation avec une propagation du faisceau (de pompe et de sonde) orientée selon la direction $\vec{z}$.
Alternativement, il est possible d'utiliser un faisceau de sonde distinct du faisceau de pompe. Dans un tel cas de figure, il est utile de décaler la fréquence de la lumière de sonde par rapport à la fréquence de la transition atomique utilisée de manière à ne pas induire de pompage résiduel avec le faisceau de sonde. Ce décalage fait qu'une mesure en absorption est peu efficace et qu'il est donc préférable de réaliser une mesure en biréfringence dite mesure polarimétrique.
De manière générale, aucun schéma connu de magnétomètre à pompage optique ne permet de mesurer la dérivée de la composante du champ magnétique orientée selon la direction de propagation du faisceau de sonde. Dans les architectures présentées en introduction qui sont basées sur un pompage optique en orientation, la composante longitudinale du champ magnétique ($B_z$, i.e. celle parallèle à la direction de propagation du faisceau de pompe) ne peut être mesurée. Par conséquent aucun des gradients de $B_z$ ne peut être mesuré. Par ailleurs, les gradients selon la direction de propagation du faisceau de sonde ne peuvent être mesurés non plus.
L'invention exposée ici consiste à mesurer les trois composantes du champ magnétique ambiant et leurs variations selon les deux axes transverses à la propagation de la lumière de sonde. Pour cela, l'invention propose de doter un magnétomètre tri-axe d'un photodétecteur qui comporte une pluralité d'unités de mesure agencées dans un plan transverse à la direction de propagation du faisceau de sonde, par exemple une matrice 2D de photodiodes ou un imageur de type capteur à transfert de charges (capteur CCD pour « Charge Coupled Device »). Ce magnétomètre peut ainsi mesurer les trois composantes du champ magnétique, déterminer leur dépendance spatiale par rapport aux deux directions transverses à la direction de propagation du faisceau de sonde et en déduire l'intégralité des composantes du tenseur de champ magnétique pour les raisons exposées ci-après.
Le magnétomètre vectoriel tri-axe permet de mesurer de manière concomitantes les trois composantes du champ magnétique, à savoir les composantes $B_x$ et $B_y$, toutes deux transverses à la direction de propagation du faisceau de sonde, et la composante $B_z$, longitudinale à la direction de propagation du faisceau de sonde. L'utilisation du photodétecteur permet d'obtenir la distribution spatiale de ces trois composantes du champ magnétique selon les deux directions orthogonales à la direction de propagation du faisceau de sonde en mesurant le signal recueilli indépendamment sur chaque unité de mesure du photodétecteur. Cela permet ainsi d'obtenir par mesure différentielle six composantes du tenseur gradient de champ magnétique :

- $\partial B_z/\partial x$ et $\partial B_z/\partial y$, gradients transverses de la composante $B_z$ du champ magnétique,

- $\partial B_x/\partial x$ et $\partial B_y/\partial y$, gradients longitudinaux des composantes $B_x$ et $B_y$ du champ magnétique,

- $\partial B_x/\partial y$ et $\partial B_y/\partial x$, un gradient transverse de la composante $B_x$ et un gradient transverse à la composante $B_y$.

Étant donné que l'aimantation de l'élément sensible utilisé pour la mesure est très faible, le volume sur lequel est réalisé la mesure de champ magnétique (la cellule comportant l'élément sensible) ne contient pas de sources de champ magnétique significatives (matériaux ferromagnétiques ou courants électriques). Par conséquent, les équations de Maxwell régissant le comportement du champ magnétique dans ce milieu s'expriment de la manière suivante :

$$\overrightarrow{rot}\,\vec{B} = \vec{0} \quad (1)$$

$$div\,\vec{B} = 0 \quad (2)$$

Ces deux équations aboutissent à des dépendances entre certaines composantes du tenseur gradient de champ magnétique.

L'équation (1) conduit à :

$$\frac{\partial B_y}{\partial z} = \frac{\partial B_z}{\partial y} \quad (3)$$

$$\frac{\partial B_x}{\partial z} = \frac{\partial B_z}{\partial x} \quad (4)$$

$$\frac{\partial B_y}{\partial x} = \frac{\partial B_x}{\partial y} \quad (5)$$

L'équation (2) conduit à :

$$\frac{\partial B_z}{\partial z} = -\left(\frac{\partial B_x}{\partial x} + \frac{\partial B_y}{\partial y}\right) \quad (6)$$

Les équations (3), (4), (5) et (6) montrent que seules cinq composantes du tenseur gradient de champ magnétique sont indépendantes. Ainsi la mesure de cinq composantes permet de caractériser complètement ce tenseur. Le magnétomètre selon l'invention permet de mesurer six composantes du tenseur de gradient et ainsi de pouvoir en déduire les trois dernières qu'il n'est pas possible de mesurer physiquement grâce aux propriétés qui découlent des équations de Maxwell (équations (3), (4) et (6).

Revenant à la figure 1, le faisceau laser (qui dans cet exemple sert à la fois de pompe et de sonde) peut être transporté par une fibre optique à l'extrémité de laquelle il diverge avec un angle dépendant de l'ouverture numérique de la fibre utilisée. Ce faisceau divergent est collimaté avant de traverser la cellule, par exemple en utilisant une lentille convergente. A la sortie de cet ensemble permettant la collimation, le faisceau passe à travers le dispositif de polarisation 3 conférant une polarisation bien spécifique à la lumière avant qu'elle ne traverse la cellule, par exemple une polarisation linéaire ou elliptique comme cela sera décrit par la suite.

Après passage dans la cellule, le faisceau laser passe à travers une lentille dite de projection qui permet d'expanser (lentille divergente) ou de focaliser (lentille convergente) le faisceau collimaté sur une aire similaire à celle de la surface sensible du photodétecteur utilisé.

Comme on l'a vu précédemment, le photodétecteur 10 comprend une pluralité d'unités de mesure agencées dans un plan transverse à la direction de propagation du faisceau de sonde. Chacune des unités de mesure fournit un signal de photodétection à une unité de traitement 6 couplée au photodétecteur 10.

L'unité de traitement 6 est configurée pour déterminer, pour chaque unité de mesure et à partir du signal de photodétection fournie par l'unité de mesure, une mesure, associée à l'unité de mesure, de chacune des trois composantes du champ magnétique ambiant. L'unité de traitement est par ailleurs configurée pour calculer au moins une différence entre les mesures, associées à des unités de mesure différentes, d'une composante du champ magnétique et délivrer un signal de mesure gradiométrique comprenant l'au moins une différence calculée. L'unité de traitement est de préférence configurée pour calculer les 6 gradients mentionnées précédemment.

Le magnétomètre peut également comprendre un système d'asservissement en boucle fermé du magnétomètre pour venir constamment soumettre l'élément sensible à un champ magnétique total nul. Le système d'asservissement comprend un régulateur 9 couplé à l'unité de traitement 6 et qui injecte un courant dans des bobines de Helmholtz 7 d'axes orthogonaux qui entourent la cellule 1 afin de générer un champ magnétique de compensation Bc tel que la somme Bc+$B_0$ est maintenue à zéro en permanence.

Alternativement, le magnétomètre peut être opéré en boucle ouverte, sans compensation du champ ambiant.

Les unités de mesure du photodétecteur 10 sont typiquement agencées sous forme matricielle et sont de préférence au nombre d'au moins 3*3. La mesure des différents gradients est obtenue en effectuant la différence entre les mesures des composantes du champ magnétique issues de la photodétection des différentes unités de mesure. Cette différence peut être effectuée entre les mesures issues de toutes les unités de mesure, permettant ainsi avec au moins 3*3 unités de mesure de fournir une base reconfigurable en longueur et en direction pour la mesure gradiométrique des trois composantes du champ magnétique.

Le photodétecteur 10 peut être une matrice de photodiodes. Alternativement, le photodétecteur 10 peut être un détecteur à transfert de charges CCD. Dans cette alternative, une unité de mesure du photodétecteur 10 peut être formée d'une pluralité de pixels voisins du détecteur CCD, le signal de photodétection d'une unité de mesure correspondant à la moyenne des signaux de photodétection individuellement délivrés par les pixels de l'unité de mesure. Le nombre de pixels voisins peut dépendre de la résolution du détecteur CCD et des caractéristiques de la cellule contenant l'élément sensible, notamment la pression du gaz qu'elle contient. Il n'est pas utile que la surface du pixel artificiel (regroupement de pixels voisins) soit inférieure à la projection du volume de diffusion des atomes sur le plan du détecteur, qui est la limite de résolution spatiale atteignable en utilisant une vapeur atomique comme élément sensible. Dans le cas de l'hélium-4 métastable à température ambiante et à une pression de 10 Torrs, cette surface vaut environ 4 $mm^2$.

Les sensibilités de chaque unité de mesure peuvent être différentes en fonction de leur position sur le photodétecteur, du fait de la répartition inhomogène de l'intensité lumineuse au sein du faisceau laser dans le plan perpendiculaire à la propagation du faisceau de sonde (la distribution de l'intensité lumineuse est habituellement gaussienne dans ce plan). Aussi, dans un mode de réalisation possible, une correction de ces différences de sensibilité est mise en œuvre par l'unité de traitement 6.

Dans un mode de réalisation préférentiel, le magnétomètre selon l'invention est un magnétomètre à résonances paramétriques. Il comprend ainsi un circuit d'excitation de résonances paramétriques qui comporte un générateur de radiofréquence 8 qui alimente les bobines d'Helmholtz 7 d'axes orthogonaux qui entourent la cellule 1 afin de générer un champ magnétique d'excitation des résonances paramétriques, également désigné par champ radiofréquence. L'ensemble cellule 1 et bobines 7 est placé au sein d'un blindage magnétique passif en μ-métal afin de l'isoler des champs magnétiques ambiants (champ terrestre et perturbations électromagnétiques), trop intenses pour respecter la condition physique γB << Γ nécessaire à l'apparition des résonances paramétriques.

Dans une première variante, le champ radiofréquence présente deux composantes oscillant chacune à sa propre fréquence d'oscillation, par exemple une première composante selon l'axe z à la pulsation $\omega$ et une deuxième composante selon l'axe y à la pulsation $\Omega$. Dans un tel cas de figure, le dispositif de polarisation 3 est configuré de manière à conférer au faisceau de pompe une polarisation linéaire selon une direction perpendiculaire à la direction des deux composantes du champ magnétique radiofréquence (i.e. selon l'axe x). Et pour déterminer une mesure, associée à une unité de mesure, de chacune des trois composantes du champ magnétique ambiant, l'unité de traitement 6 est configurée pour réaliser une détection synchrone du signal de photodétection fourni par l'unité de mesure à un harmonique de chacune des fréquences d'oscillation ($\omega$ et $\Omega$) et à un inter-harmonique desdites fréquences d'oscillation ($\omega \pm \Omega$).

Dans une deuxième variante, il est également possible d'utiliser une architecture tri-axe de magnétomètre à pompage optique reposant sur une polarisation elliptique de la lumière de pompage et l'application de trois champs radiofréquences telle que présentée dans la demande de brevet EP 3 524 990 A1. Dans cette variante, le circuit d'excitation de résonances paramétriques est ainsi configuré de manière à ce qu'il induise dans la cellule un champ magnétique radiofréquence présentant trois composantes oscillant chacune à sa propre fréquence d'oscillation. Le dispositif de polarisation est configuré de manière à conférer au faisceau de pompe une polarisation elliptique dont la composante polarisée circulairement est dirigée selon l'axe de propagation du faisceau de pompe z et la composante polarisée linéairement (demi-grand-axe de l'ellipse) est dirigée selon la direction x. Et pour déterminer une mesure, associée à une unité de mesure, de chacune des trois composantes du champ magnétique ambiant, l'unité de traitement 6 est configurée pour réaliser une détection synchrone du signal de photodétection fourni par l'unité de mesure à un harmonique de chacune des fréquences d'oscillation.

L'invention n'est pas limitée à un magnétomètre à résonances paramétriques mais s'étend à toute autre architecture de magnétomètre à pompage optique permettant une mesure des trois composantes du champ magnétique, comme par exemple celle présentée dans l'article de X. Qiu et al., Applied Physics Letters 116, 034001 (2020), intitulé « Three-axis atomic magnetometer for nuclear magnetic resonance gyroscopes ». Cette architecture, plus complexe que celles décrites ci-dessus, est basée sur l'utilisation de deux espèces atomiques, typiquement un alcalin pompé optiquement et un gaz noble présent dans la même cellule. Deux des composantes du champ sont mesurées par l'intermédiaire de la résonance paramétrique n=1 de l'alcalin. La troisième composante est obtenue à partir de la fréquence de précession du gaz noble

L'invention qui permet de mesurer des gradients sur des bases très courtes trouve application non seulement dans le domaine médical (magnétoencéphalographie et magnétocardiographie par exemple), mais également dans des procédés de magnéto-relaxométrie de particules magnétiques ainsi que pour l'imagerie de pièces ferromagnétiques (par exemples en acier) pour du contrôle non destructif (localisation de défauts tels que de débuts de fissuration par exemple).

L'invention n'est pas limitée au magnétomètre tel que décrit précédemment mais s'étend également à un procédé de mesure d'un gradient spatial d'un champ magnétique au moyen d'un tel magnétomètre, ce procédé comprenant notamment la détermination, pour chaque unité de mesure et à partir du signal de photodétection fournie par l'unité de mesure, d'une mesure, associée à l'unité de mesure, de chacune des trois composantes du champ magnétique ambiant, le calcul d'au moins une différence entre les mesures, associées à des unités de mesure différentes, d'une composante du champ magnétique et la fourniture d'un signal de mesure gradiométrique comprenant l'au moins une différence calculée.

**Revendications**

1. Magnétomètre à pompage optique vectoriel tri-axe, comprenant :

   - une cellule (1) remplie d'un gaz atomique soumis à un champ magnétique ambiant dont la projection sur trois axes de coordonnées rectangulaires en définit trois composantes,
   - un photodétecteur (10) agencé de manière à recevoir un faisceau de sonde ayant traversé la cellule,

   **caractérisé en ce que** le photodétecteur (10) comprend une pluralité d'unités de mesure agencées dans un plan transverse à une direction de propagation du faisceau de sonde, les unités de mesure fournissant chacune un signal de photodétection, et **en ce qu'**il comprend en outre une unité de traitement (6) couplée au photodétecteur, ladite unité étant configurée :

   - pour déterminer, pour chaque unité de mesure et à partir du signal de photodétection fournie par l'unité de mesure, une mesure, associée à l'unité de mesure, de chacune des trois composantes du champ magnétique ambiant ; et
   - pour calculer au moins une différence entre les mesures, associées à des unités de mesure différentes, d'une composante du champ magnétique et délivrer un signal de mesure gradiométrique comprenant l'au moins une différence calculée.

2. Magnétomètre selon la revendication 1, dans lequel les unités de mesure du photodétecteur (10) sont agencées sous forme matricielle et sont au nombre d'au moins 3*3.

3. Magnétomètre selon l'une des revendications 1 et 2, dans lequel le photodétecteur (10) est une matrice de photodiodes.

4. Magnétomètre selon l'une des revendications 1 et 2, dans lequel le photodétecteur (10) est un détecteur à transfert de charges.

5. Magnétomètre selon la revendication 4, dans lequel une unité de mesure du photodétecteur (10) est formée d'une pluralité de pixels voisins du détecteur à transfert de charges, le signal de photodétection d'une unité de mesure correspondant à la moyenne des signaux de photodétection individuellement délivrés par les pixels de l'unité de mesure.

6. Magnétomètre selon l'une des revendications 1 à 5, comprenant en outre :

   - un circuit d'excitation de résonances paramétriques (7, 8) configuré de manière à ce qu'il induise dans la cellule un champ magnétique radiofréquence présentant deux composantes oscillant chacune à sa propre fréquence d'oscillation,
   - une source de pompage optique (2) agencée pour émettre en direction de la cellule (1) un faisceau de pompe accordé sur une transition atomique, le faisceau de sonde étant identique à ou distinct du faisceau de pompe,
   - un dispositif de polarisation (3) configuré de manière à conférer une polarisation linéaire au faisceau de pompe,

   et dans lequel, pour déterminer une mesure, associée à une unité de mesure, de chacune des trois composantes du champ magnétique ambiant, l'unité de traitement (6) est configurée pour réaliser une détection synchrone du signal de photodétection fourni par l'unité de mesure à un harmonique de chacune des fréquences d'oscillation et à un inter-harmonique desdites fréquences d'oscillation.

7. Magnétomètre selon l'une des revendications 1 à 5, comprenant en outre :

   - un circuit d'excitation de résonances paramétriques (7, 8) configuré de manière à ce qu'il induise dans la cellule un champ magnétique radiofréquence présentant trois composantes oscillant chacune à sa propre fréquence d'oscillation,
   - une source de pompage optique (2) agencée pour émettre en direction de la cellule (1) un faisceau de pompe accordé sur une transition atomique, le faisceau de sonde étant identique à ou distinct du faisceau de pompe,
- un dispositif de polarisation (3) configuré de manière à conférer une polarisation elliptique au faisceau de pompe,

et dans lequel, pour déterminer une mesure, associée à une unité de mesure, de chacune des trois composantes du champ magnétique ambiant, l'unité de traitement (6) est configurée pour réaliser une détection synchrone du signal de photodétection fourni par l'unité de mesure à un harmonique de chacune des fréquences d'oscillation.

8.  Magnétomètre selon l'une des revendications 1 à 7, dans lequel les trois composantes du champ magnétique ambiant comprennent deux composantes, $B_x$ et $B_y$, transverses à la direction de propagation du faisceau de sonde et une composante, $B_z$, longitudinale à la direction de propagation du faisceau de sonde et dans lequel le signal de mesure gradiométrique comprend :

- les gradients transverses de la composante $B_z$, $\partial B_z/\partial x$ et $\partial B_z/\partial y$,
- les gradients longitudinaux des composantes $B_x$ et $B_y$, $\partial B_x/\partial x$ et $\partial B_y/\partial y$,
- un gradient transverse de la composante $B_x$ et un gradient transverse de la composante $B_y$, $\partial B_x/\partial y$ et $\partial B_y/\partial x$.

9.  Procédé de mesure d'un gradient spatial d'un champ magnétique au moyen d'un magnétomètre à pompage optique vectoriel tri-axe qui comprend :

- une cellule (1) remplie d'un gaz atomique soumis à un champ magnétique ambiant dont la projection sur trois axes de coordonnées rectangulaires en définit trois composantes,
- un photodétecteur (10) agencé de manière à recevoir un faisceau de sonde ayant traversé la cellule, le photodétecteur (10) comprenant une pluralité d'unités de mesure agencées dans un plan transverse à une direction de propagation du faisceau de sonde, les unités de mesure fournissant chacune un signal de photodétection, et
- une unité de traitement (6) couplée au photodétecteur,

ledit procédé comprenant les étapes suivantes mises en œuvre par l'unité de traitement :

- détermination, pour chaque unité de mesure et à partir du signal de photodétection fournie par l'unité de mesure, d'une mesure, associée à l'unité de mesure, de chacune des trois composantes du champ magnétique ambiant ; et
- calcul d'au moins une différence entre les mesures, associées à des unités de mesure différentes, d'une composante du champ magnétique et fourniture d'un signal de mesure gradiométrique comprenant l'au moins une différence calculée.

FIG. 1

$$\begin{bmatrix} \dfrac{\partial B_z}{\partial x} \\[8pt] \dfrac{\partial B_z}{\partial y} \\[8pt] \dfrac{\partial B_x}{\partial x} \\[8pt] \dfrac{\partial B_y}{\partial y} \\[8pt] \dfrac{\partial B_x}{\partial y} \\[8pt] \dfrac{\partial B_y}{\partial x} \end{bmatrix}$$

EP 3 919 928 A1

Europäisches
Patentamt

European
Patent Office

Office européen
des brevets

**RAPPORT DE RECHERCHE EUROPEENNE**

Numéro de la demande

EP 21 17 7200

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 3 364 204 A1 (COMMISSARIAT ENERGIE ATOMIQUE [FR]) 22 août 2018 (2018-08-22) * alinéas [0016] - [0022], [0025], [0026]; figures 1,2 * | 1-5,8,9 | INV. G01R33/26 G01R33/022 |
| Y | US 8 212 556 B1 (SCHWINDT PETER [US] ET AL) 3 juillet 2012 (2012-07-03) | 1,4-9 | |
| A | * colonne 12, lignes 6-48; figures 2A-2D, 3 * * colonne 2, ligne 8 - colonne 4, ligne 48 * | 2,3 | |
| Y | US 2019/391215 A1 (OSAKA TAKANOBU [JP]) 26 décembre 2019 (2019-12-26) * alinéas [0001] - [0003] * | 1-9 | |
| Y | US 2019/250223 A1 (PALACIOS LALOY AGUSTIN [FR]) 15 août 2019 (2019-08-15) * alinéas [0012], [0019], [2031] - [0032], [0058], [0059], [0061], [0062]; figures 1-5 * | 1,6,7,9 | |
| | | | DOMAINES TECHNIQUES RECHERCHES (IPC) |
| Y | US 2004/140799 A1 (ROMALIS MICHAEL [US] ET AL) 22 juillet 2004 (2004-07-22) * alinéas [0011] - [0053], [0164] - [0166]; figures 6, 10-12 * * alinéas [0046], [0101], [0135], [136145]; exemple 1 * | 1,9 | G01R |
| Y | US 2018/210039 A1 (SHALEV GIL [IL]) 26 juillet 2018 (2018-07-26) * alinéas [0011], [0019], [0035], [0148], [0149], [0160], [0147]; figures 2G, 3A * | 1,9 | |

-/--

Le présent rapport a été établi pour toutes les revendications

| Lieu de la recherche | Date d'achèvement de la recherche | Examinateur |
|---|---|---|
| Munich | 1 octobre 2021 | Loughman, John |

EPO FORM 1503 03.82 (P04C02)

page 1 de 2

Europäisches Patentamt

European Patent Office

Office européen des brevets

**RAPPORT DE RECHERCHE EUROPEENNE**

Numéro de la demande

EP 21 17 7200

| | | DOCUMENTS CONSIDERES COMME PERTINENTS | | |
|---|---|---|---|---|
| | Catégorie | Citation du document avec indication, en cas de besoin, des parties pertinentes | Revendication concernée | CLASSEMENT DE LA DEMANDE (IPC) |
| | A | SELTZER S ET AL: "Unshielded three-axis vector operation of a spin-exchange-relaxation-free atomic magnetometer", APPLIED PHYSICS LETTERS, A I P PUBLISHING LLC, US, vol. 85, no. 20, 15 novembre 2004 (2004-11-15), pages 4804-4806, XP012063471, ISSN: 0003-6951, DOI: 10.1063/1.1814434 * le document en entier * ----- | 1-9 | |
| | A | US 2013/127458 A1 (MIZUTANI NATSUHIKO [JP] ET AL) 23 mai 2013 (2013-05-23) * alinéas [0001], [0005] - [0008], [0087]; figures 1-6; exemple 2 * ----- | 1-9 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 1 octobre 2021 | Loughman, John |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 21 17 7200

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-10-2021

| Document brevet cité au rapport de recherche | | Date de publication | Membre(s) de la famille de brevet(s) | | Date de publication |
|---|---|---|---|---|---|
| EP 3364204 | A1 | 22-08-2018 | EP | 3364204 A1 | 22-08-2018 |
| | | | FR | 3062922 A1 | 17-08-2018 |
| US 8212556 | B1 | 03-07-2012 | AUCUN | | |
| US 2019391215 | A1 | 26-12-2019 | JP | 2020003270 A | 09-01-2020 |
| | | | US | 2019391215 A1 | 26-12-2019 |
| US 2019250223 | A1 | 15-08-2019 | EP | 3524990 A1 | 14-08-2019 |
| | | | FR | 3077884 A1 | 16-08-2019 |
| | | | US | 2019250223 A1 | 15-08-2019 |
| US 2004140799 | A1 | 22-07-2004 | US | 2004140799 A1 | 22-07-2004 |
| | | | US | 2005206377 A1 | 22-09-2005 |
| US 2018210039 | A1 | 26-07-2018 | EP | 3325990 A1 | 30-05-2018 |
| | | | US | 2018210039 A1 | 26-07-2018 |
| | | | WO | 2017013657 A1 | 26-01-2017 |
| US 2013127458 | A1 | 23-05-2013 | JP | 5539099 B2 | 02-07-2014 |
| | | | JP | 2012042237 A | 01-03-2012 |
| | | | US | 2013127458 A1 | 23-05-2013 |
| | | | WO | 2012020716 A1 | 16-02-2012 |

EPO FORM P0460

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- EP 3524990 A1

**Littérature non-brevet citée dans la description**

- **KOMINIS et al.** *Nature,* 2003, vol. 422
- **ZHANG et al.** *AIP Advances,* 2018, vol. 8, 125028
- **COLOMBO et al.** *Optics Express,* 2016, vol. 24 (14
- **X. QIU et al.** Three-axis atomic magnetometer for nuclear magnetic resonance gyroscopes. *Applied Physics Letters,* 2020, vol. 116, 034001